(19) Europäisches Patentamt

European Patent Office

Office européen des brevets

(11) EP 2 200 180 B1

(12) **EUROPEAN PATENT SPECIFICATION**

(45) Date of publication and mention
of the grant of the patent:
**23.09.2015 Bulletin 2015/39**

(21) Application number: **08021280.6**

(22) Date of filing: **08.12.2008**

(51) Int Cl.:
***H03H 17/02*** *(2006.01)*

(54) **Subband signal processing**

Subband-Signalverarbeitung

Traitement de signal de sous-bande

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**23.06.2010 Bulletin 2010/25**

(73) Proprietor: **Harman Becker Automotive Systems
GmbH
76307 Karlsbad (DE)**

(72) Inventor: **Christoph, Markus
94315 Straubing (DE)**

(74) Representative: **Westphal, Mussgnug & Partner
Patentanwälte mbB
Herzog-Wilhelm-Strasse 26
80331 München (DE)**

(56) References cited:
• SCHONLE M ET AL: "Parametric approximation
of room impulse responses based on wavelet
decomposition" APPLICATIONS OF SIGNAL
PROCESSING TO AUDIO AND ACOUSTICS, 1993.
FINAL PROGRAM AND PAPER SUMMARIES.,
1993 IEEE WORKSHOP ON NEW PALTZ, NY, USA
17-20 OCT. 1993, NEW YORK, NY, USA,IEEE, 17
October 1993 (1993-10-17), pages 68-71,
XP010130076 ISBN: 978-0-7803-2078-9
• R.G. LYONS: "UNDERSTANDING DIGITAL
SIGNAL PROCESSING" 1997, ADDISON WESLEY
LONGMAN INC. , XP002530604 Retrieved from
the Internet: URL:http://www.dspguru.com/info/
terms/filt term/index2.htm> [retrieved on
2009-06-04] * page 1, lines 1-11; figures F-1 *

**Description**

TECHNICAL FIELD

This invention relates to signal processing and, in particular, to subband audio signal processing.

BACKGROUND OF THE INVENTION

Subband processing of signals is widely used in audio signal processing systems. The publication M. Schoenle et al.: "Parametric Approximation of Room Impulse Responses based on wavelet Decomposition", Proc. IEEE Workshop on Applications of Signal Processing to Audio and Acoustics, New Paltz, 1993, illustrates one example of a complementary filter bank for subband signal processing. In such systems, signals to be processed are decomposed into an array of at least two frequency bands. Subsequently, processing is done on a per-band basis. To this end, an analysis filter bank is employed to decompose the signal into a predetermined number of frequency bands. Then, different operations are performed on the different subband signals. The processed subband signals are then recomposed into the desired processed signal by use of a synthesis filter bank. However, in prior systems use of such analysis and synthesis filters introduced significant delay. Known implementations of the filters employed in the analysis and synthesis filter banks are typically linear phase, i.e. finite impulse response filters (FIR). This is a result of employing in known implementations either a linear phase analysis filter and a linear phase synthesis filter, i.e. finite impulse response filters (FIR), or a minimum phase analysis filter and a maximum phase synthesis filter or vice versa. However, regardless of what filter types, linear phase or minimum/maximum phase filters are used, the implementation is unsatisfactory in terms of computational efficiency. The publication R.G. Lyons: "Understanding Digital Signal Processing", Addison Wesley Longman, Inc., 1997, covers some general aspects of digital signal processing.

SUMMARY OF THE INVENTION

An apparatus for subband processing of an input signal is presented in claim 1. The apparatus comprises an analysis filter bank including two signal branches for establishing two subbands and for decomposing the input signal into two subband signals, the first branch of which includes a decimation filter, a subsequent down-sampling unit and a subsequent basis filter, with the second branch including an allpass filter and a subtractor that is connected downstream of the allpass filter and the basis filter via a first up-sampling unit and a subsequent first interpolation filter. Two subband signals are supplied to two subband signal processors from the analysis filter bank for processing the subband signals in the corresponding subbands and for generating two processed subband signals. Further, the apparatus comprises a synthesis filter bank for synthesizing an output signal, the filter bank includes an adder supplied with the processed subband signal of the second branch and with the processed subband signal of the first branch via a second up-sampling unit and a subsequent second interpolation filter. Either the decimation filter is an infinite impulse response (IIR) filter or the first interpolation filter is an infinite impulse response (IIR) filter or both are infinite impulse response (IIR) filters, and the allpass filter has a phase response adapted to compensate for the phase response of those of the decimation filter and the first interpolation filter which are infinite impulse responses (IIR filters).

The corresponding method is presented in claim 14.

BRIEF DESCRIPTION OF THE DRAWING

FIG. 1 shows, in block diagram form, a novel subband signal processing apparatus for processing two subbands;

FIG. 2 shows, in block diagram form, a third order IIR filter of direct form II, which can be employed in the apparatus of FIG. 1;

FIG. 3 shows, in block diagram form, a third order allpass filter of direct form II, which can be employed in the apparatus of FIG. 1;

FIG. 4 is a graphical representation of the ideal frequency and phase characteristics of a low pass filter cascade of decimation and interpolation filter and a corresponding allpass filter, which can be employed in the apparatus of FIG. 1;

FIG. 5 is a graphical representation of the frequency characteristics of a frequency swapped decimation filter, basis filter and an interpolation filter for aliasing free subband signal processing; and

FIG. 6 shows, in simplified block diagram form, a subband signal processing apparatus for processing a multiplicity of octave-spaced subbands; and

FIG. 7 shows, in simplified block diagram form, details of a basis filter, which can be employed in the apparatus of FIG. 1.

DETAILED DESCRIPTION

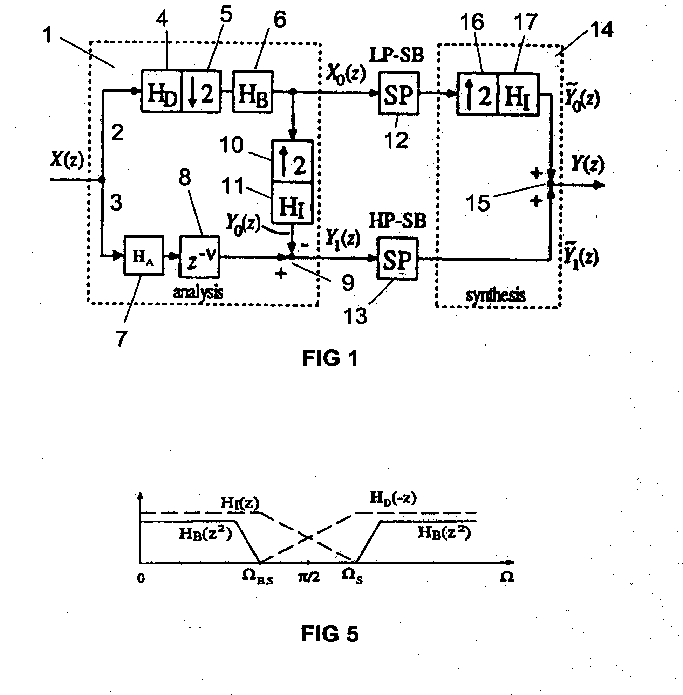

FIG. 1 illustrates an example of a novel apparatus for subband processing of an input audio signal X(z). The apparatus includes an analysis filter bank 1 that receives the audio signal X(z) and that has two signal branches 2, 3 for establishing two subbands, a lowpass subband LP-SB and a highpass subband HP-SB, and for decomposing the audio signal X(z) into two respective subband signals $X_0(z)$ and $Y_1(z)$. The first branch 2 includes a decimation filter 4 having a transfer function $H_D$, a subsequent down-sampling unit 5 for decreasing the sample rate of the audio signal X(z) by two, and a subsequent basis filter 6 having a transfer function $H_B$. The second branch 3 includes an allpass filter 7 having a transfer function $H_A$, a delay element 8 having a delay time $z^{-v}$, and a subtractor 9 that is connected downstream of the allpass filter 7 and the delay element 8 and that is also connected downstream of the basis filter 6 via a first up-sampling unit 10 and a subsequent first interpolation filter 11 that generates a signal $Y_0(z)$.

Two subband signal processors 12, 13 that are supplied with the two subband signals $X_0(z)$ and $Y_1(z)$, respectively, process these signals in the corresponding subbands LP-SB, HP-SB and generates two processed subband signals. A subsequent synthesis filter bank 14 for synthesizing a processed audio signal Y(z) includes an adder 15 that is supplied with a processed subband signal $\tilde{Y}_1(z)$ of the second branch 3 and that is supplied with a processed subband signal $\tilde{Y}_0(z)$ of the first branch 2 via a second up-sampling unit 16 and a subsequent second interpolation filter 17. The adder supplies the processed audio signal Y(z). In the present example, the decimation filter 4 and the interpolation filters 11, 17 are infinite impulse response (IIR) filters having identical lowpass transfer functions. The allpass filter 7 exhibits the recursive part of the cascaded filters 4 and 11. Accordingly, the allpass filter 7 has a phase response adapted to compensate for the phase responses of the decimation filter 4 and the interpolation filter 11.

The basis filter 6 is, in the present example, a linear phase filter such as a finite impulse response (FIR) filter or a linear phase infinite impulse response (IIR) filter. Linear phase can be a very desirable property in some applications. Linear phase defines a constant delay for all frequency components between the output and the input. The requirement of a strictly linear phase is the primary reason for using FIR filters. A linear phase filter is a filter whose phase response is a linear function of the frequency. In contrast, the decimation filter 4 as well as the interpolation filters 11 and 17 are IIR minimum phase filters. A filter is called minimum phase if both its transfer function and the inverse of its transfer function are stable and causal. In other words, both have their zeros and poles inside the unit circle.

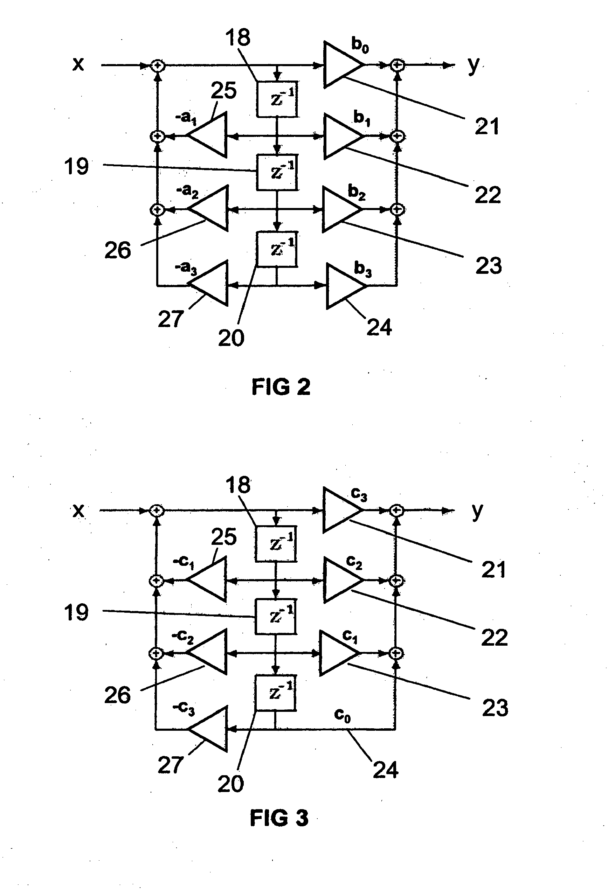

FIGS. 2 and 3 show examples of a 3rd order lowpass IIR filter of direct form II (FIG. 2) and a 3rd order allpass filter of direct form II (FIG. 3) which can be employed in the apparatuses illustrated above. The basic structure of such filters includes a delay line having, in the case of a 3rd order filter, three delay elements 18, 19, 20 connected in series with taps in between. The input of the delay line (input of delay element 18), the taps (outputs of delay elements 18 and 19) as well as the end of the delay line (output of delay element 20) are weighted by multipliers with filter coefficients $b_0$, $b_1$, $b_2$, and $b_3$ and subsequently summed up to form an output signal y. Furthermore, the taps (outputs of delay elements 18 and 19) as well as the end of the delay line (output of delay element 20) are weighted by multipliers with filter coefficients $-a_1$, $-a_2$, and $-a_3$ and subsequently summed up together with an input signal x to form a signal supplied to the input of the delay line (input of delay element 18).

In general, the transfer function of an all pass filter (FIG. 3) is a special case of an IIR filter (FIG. 2). The transfer function H(z) of an 3rd order IIR filter as shown in FIG. 2 is:

$$H(z) = y/x$$
$$= (b_0 + b_1 \cdot z^{-1} + b_2 \cdot z^{-1} + b_3 \cdot z^{-1}) / (1 + a_1 \cdot z^{-1} + a_2 \cdot z^{-1} + a_3 \cdot z^{-1}) \quad (1)$$

The allpass function of such filter is:

$$c_0 = 1, \quad c_1 = a_1, \quad c_2 = a_2, \quad c_3 = a_3.$$

Instead of the filter structure and order employed in connection with the filters of FIGS. 2 and 3, other structures and orders may be used as the case may be. Such structure may be e.g., direct form I, lattice etc. The simplest allpass

3

filter is a unit-delay $H(z) = e^{j\varphi\omega T} = e^{j\varphi(2\pi f/fs)}$ where f represents the frequency in [Hz] and T=1/fs the sampling period in [s].

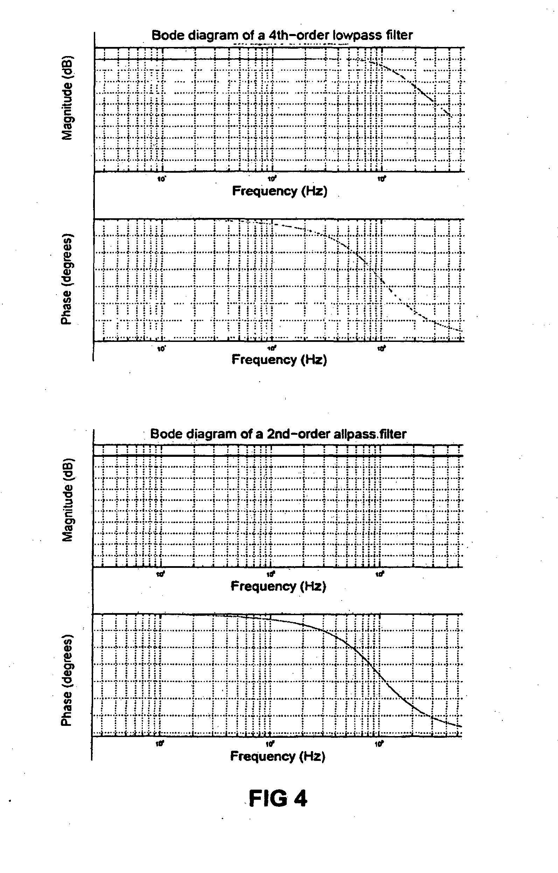

In FIG. 4 the behavior of a 4th order low pass filter in comparison to the corresponding 2nd order allpass filter is shown. As can readily be seen, the phase characteristics (phase over frequency) of both filters are identical. However, the amplitude characteristics (magnitude over frequency) of both filters differ in that the amplitude decreases with increasing frequency in the lowpass filter while the amplitude is constant over frequency in the allpass filter.

The novel apparatus as shown in FIG. 1, employs an additional basis filter $H_B(z)$ changing the characteristics of the analysis filter bank considerably. By means of the lowpass filter $H_B(z)$ the splitting frequency can be shifted from $\pi/2$ to lower frequencies and the aliasing components in the subbands can be totally avoided. Furthermore, the transition bandwidth between the subbands can be controlled by one filter and the transition bandwidth can be made small while maintaining a constant computational efficiency.

Aliasing is not completely cancelled if different signal processing (SP) is done in the subbands. However, a suitable transfer function $H_B(z)$ of the basis filter can solve this problem. The lowpass signal $X_0(z)$ in the apparatus of FIG. 1 reads in terms of the input signal $X(z)$ as:

$$X_0(z) = \tfrac{1}{2}H_D(z^{1/2}) \cdot X(z^{1/2}) \cdot H_B(z)$$
$$+\tfrac{1}{2}H_D(-z^{1/2}) \cdot X(-z^{1/2}) \cdot H_B(z) \qquad (2)$$

The interpolated signal is accordingly:

$$Y_0(z) = X_0(z^2) \cdot H_I(z)$$
$$= \tfrac{1}{2}H_D(z) \cdot H_I(z) \cdot H_B(z^2) \cdot X(z)$$
$$+\tfrac{1}{2}H_D(-z) \cdot H_I(z) \cdot H_B(z^2) \cdot X(-z) \qquad (3)$$

The highpass subband signal $Y_1(z)$ is generated by subtracting $Y_0(z)$ from the delayed and allpass filtered input signal $z^{-v} \cdot X(z)$:

$$Y_1(z) = H_A(z) \cdot z^{-v} \cdot X(z) - Y_0(z) \qquad (4)$$

Assuming that the signal processor SP in the lowpass subband LP-SB and the highpass subband HP-SB is a pure scaling by factors $\alpha_{LP}$ and $\alpha_{HP}$, respectively, the two signals $\tilde{Y}_0(z)$ and $\tilde{Y}_1(z)$ in the synthesis filter banks illustrated in FIGS. 1 and 2 are:

$$\tilde{Y}_0(z) = \alpha_{LP} \cdot X_0(z^2) \cdot H_I(z) = \alpha_{LP} \cdot Y_0(z) \qquad (5)$$

$$\tilde{Y}_1(z) = \alpha_{HP} \cdot Y_1(z) \qquad (6)$$

and the output signal $Y(z)$ as a sum of the two signals is

$$Y(z) = \tilde{Y}_0(z) + \tilde{Y}_1(z)$$
$$= \alpha_{HP} \cdot x^{-v} \cdot X(z) + Y_0(z) \cdot (\alpha_{LP} - \alpha_{HP})$$
$$= X(z) \cdot [\alpha_{HP} \cdot H_A(z) \cdot z^{-v} + (\alpha_{LP} - \alpha_{HP}) \cdot \tfrac{1}{2}H_D(z) \cdot H_I(z) \cdot H_B(z^2)]$$
$$+X(-z) \cdot [(\alpha_{LP} - \alpha_{HP}) \cdot \tfrac{1}{2} H_D(-z) \cdot H_I(z) \cdot H_B(z^2)] \qquad (7)$$

The term starting with $X(-z)$ in equation (7) describes the remaining aliasing at the output of the filter bank. In a normal Laplacian pyramid type filter bank, where $H_B(z) = 1$, aliasing is not cancelled in the presence of different scaling factors $\alpha_{LP}$ and $\alpha_{HP}$ in the subbands. This also applies to subband signal processing with finite quantization errors or with different frequency responses.

The frequency characteristics of a frequency swapped decimation filter having a transfer function $H_D(-z)$, a basis filter having a transfer function $H_B(z^2)$ and a second order interpolation filter having a transfer function $H_I(z)$ for aliasing free subband signal processing is shown in FIG. 5.

Assuming that in the subband the signals are not changed by the signal processors 12, 13, aliasing is cancelled perfectly in the synthesis filter bank 14. This is achieved by means of an additional filter, the basis filter having the transfer function $H_B(z)$. Since $H_D(z) = H_I(z)$, both with a pass band cut-off frequency $\Omega_P$ and a stop band cut-off frequency $\Omega_S$, and since the stop band cut-off frequency $\Omega_{B,S}$ of $H_B(z)$ is not greater than $\Pi-\Omega_S$, $H_D(-z) \cdot H_I(z) \cdot HB(z^2)$ is zero for $z = e^{j\Omega}$ with normalized frequencies $0 \leq \Omega \leq n$. Accordingly, the aliasing terms (2) and (3) are eliminated providing an aliasing-free subband processing.

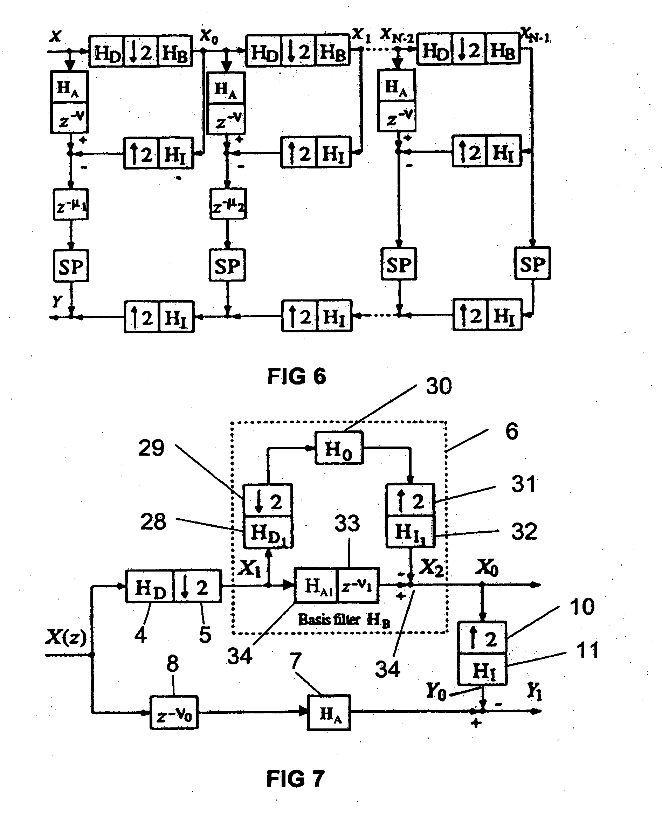

The two-band filter banks of FIG. 1 can be extended to an n-band filter bank (n>2) with octave band splitting by a continued splitting of the respective lowpass subband into two subbands of equal bandwidth as shown in FIG. 6. This means that n analysis filter banks, n subband signal processors and n synthesis filter banks are cascaded such that the first branch of at least one analysis filter bank includes the first and second branches of a subsequent analysis filter bank in the cascade. The lowpass output signal $X_0(z)$ of the first analysis filter bank is fed into the next analysis filter bank being operated at half of the sampling rate of the first one. Its lowpass output signal $X_1(z)$ is fed into the next analysis filter band etc. All highpass subband signals and the lowpass signal of the last analysis filter bank are output in a synchronized manner by respective delays $z^{-\mu 1}$, $z^{-\mu 2}$ for subband signal processing (SP) and then reconstructed by interpolation sections to generate output signal Y.

The two channel analysis filter bank of FIG. 1 may be also adapted such that the basis filter 6 having the transfer function $H_B(z)$ is implemented by means of a multi-rate complementary arrangement as shown in FIG. 7. The input signal $X_1(z)$ of such a basis filter is first down-sampled by a decimation highpass filter 28 having a transfer function $H_{D1}(z)$ and a down-sampler 29 by a factor of 2. Then it is filtered in a kernel filter 30 (sub-base filter) having a transfer function $H_0(z)$ which is responsible for the transition slope between the pass band and the stop band of the basis filter 6. The output signal is then interpolated by a factor of 2 by an up-sampler 31 and an interpolation highpass filter 32 having a transfer function $H_{I1}(z)$, to form a signal $X_2(z)$. The input signal $X_1(z)$ is further delayed by a delay element 33 and the Signal $X_2(z)$ is subtracted from the delayed signal $X_1(z)$ to form signal $X_0(z)$. Altogether, the lowpass filter $H_0(z)$ is mapped into a highpass filter with double sampling frequency. The transition bandwidth with respect of the sampling frequency has been reduced by a factor of 2.

In a last step, by subtracting the output signal $X_2(z)$ from the delayed input signal $z^{-v1} \cdot X_1(z)$, the complementary lowpass filter $H_B(z)$ is obtained. The cut-off frequency of this filter is between $\pi/2$ and $\pi$. The transition bandwidth of the basis filter can be arbitrarily reduced by continued decimation, interpolation and complementary operation as described above. Due to the decreasing sample rates the filter operations per time unit are limited and tend to be twice of the filter operations of the first decimation/interpolation section. Thus the bandwidth can be kept small while the computational efficiency is nearly constant. On the other hand, it may be noted that the delays and the number of delay elements needed for the complementary operations increase with decreased transition bandwidth.

The decimation filter and the interpolation filter may be FIR filters in the present example. However, instead of using such a linearphase decimation filter and such a linearphase interpolation filter, in the apparatus described with reference to FIG. 7, the basis filter 6 itself can be implemented as a multi-rate complementary arrangement as shown in FIG. 1. Accordingly, again the FIR filters are replaced by IIR lowpass filters 28 and 32 and a corresponding allpass filter 34 having a transfer function $H_{A1}$ is cascaded to the delay line 33 that solely compensates for the delay (phase response) of the linearphase sub-basis filter 30.

The novel apparatuses presented herein reduce the delay and increase the computational efficiency in subband processing of audio systems substantially by employing IIR minimum phase filters at least in the analysis filter bank. This is possible because it was recognized that the human auditory system is relatively insensitive to phase distortion in the processed audio signals.

Although various exemplary embodiments of the invention have been disclosed, it will be apparent to those skilled in the art that various changes and modifications can be made which will achieve some of the advantages of the invention without departing from the scope of the invention as defined by the append claims. It will be obvious to those reasonably skilled in the art that other components performing the same functions may be suitably substituted. Further, the methods of the invention may be achieved in either all software implementations, using the appropriate processor instructions, or in hybrid implementations that utilize a combination of hardware logic and software logic to achieve the same results. Such modifications to the inventive concept are intended to be covered by the appended claims.

**Claims**

1. An apparatus for subband processing of an input signal comprising:

an analysis filter bank (1) including two signal branches (2, 3) for establishing two subbands and for decomposing the input signal into two subband signals, the first branch (2) of which includes a decimation filter (4), a subsequent down-sampling unit (5) and a subsequent basis filter (6),

and the second branch (3) includes an allpass filter (7) and a subtractor (9) that is connected downstream of the allpass filter (7) and that is connected downstream of the basis filter (6) via a first up-sampling unit (10) and a subsequent first interpolation filter (11);

two subband signal processors (12, 13) supplied with the two subband signals from the analysis filter bank (1) for processing the subband signals in the corresponding subbands and for generating two processed subband signals; and

a synthesis filter bank (14) for synthesizing an output signal, the synthesis filter bank (14) includes an adder (15) that is supplied with the processed subband signal of the second branch (3) and that is supplied with the processed subband signal of the first branch (2) via a second up-sampling unit (16) and a subsequent second interpolation filter (17); the apparatus being **characterized in that**

either the decimation filter (4) is an infinite impulse response (IIR) filter or the first interpolation filter (11) is an infinite impulse response (IIR) filter or both are infinite impulse response (IR) filters; and

the allpass filter (7) has a phase response adapted to compensate for the phase response of those of the decimation filter (4) and the first interpolation filter (11) which are infinite impulse response (IIR) filters.

2.  The apparatus of claim 1, where the basis filter (6) comprises a finite impulse response (FIR) filter.

3.  The apparatus of claim 1, where the basis filter (6) comprises a linear phase infinite impulse response (IIR) filter.

4.  The apparatus of one of claims 1-3, where the second branch includes a first delay (8) unit that is connected in series with the allpass filter (7) and that has a phase response adapted to compensate for the phase response of at least the basis filter.

5.  The apparatus of one of claims 1-4, where the decimation filter (4), the first interpolation filter (11) and the second interpolation filter (17) have identical transfer functions.

6.  The apparatus of one of claims 1-5, where the decimation (4) filter, the first interpolation filter (11) and the second interpolation filter (17) are low pass filters.

7.  The apparatus of one of claims 1-6, where the decimation filter (4), the first interpolation filter (11) and the second interpolation filter (17) are minimum phase impulse response (IIR) filters.

8.  The apparatus of one of claims 1-7, where, in the analysis filter bank (1), the decimation filter (4) is connected upstream of the down-sampling unit (6) and the basis filter(6) .

9.  The apparatus of one of claims 1-8, further comprising n analysis filter banks, n subband signal processors and n synthesis filter banks are cascaded such that the first branch of at least one analysis filter bank includes the first and second branches of a subsequent analysis filter bank in the cascade.

10. The apparatus of one of claims 1-9, where the basis filter (6) is multirate-complementary filter.

11. The apparatus of one of claims 1-10, where the basis filter (6) comprises two signal branches supplied with a sub-basis filter input signal, the first branch of which includes a second decimation filter (28), a second down-sampling unit (29) and a further basis filter (30), and the second branch includes a second delay unit (33) and a second subtractor that provides a basis filter output signal; the second subtractor is connected downstream of the second delay unit (33) and is connected downstream of the further basis filter (30) via a third up-sampling unit (31) and a subsequent third interpolation filter (32).

12. The apparatus of claim 11, where
    either the second decimation filter (28) is an infinite impulse response (IIR) filter or the third interpolation filter (32) is an infinite impulse response (IIR) filter or both are infinite impulse response (IIR) filters;
    a second allpass filter (34) is connected in series to the second delay unit (33); and
    the second allpass (34) filter has a phase response adapted to compensate for the phase response of the second decimation filter (28) or the third interpolation filter (32) or both.

**13.** The apparatus of claim 11 or 12, where the second delay unit (33) has a phase response adapted to compensate for the phase response of at least the sub-basis filter (30).

**14.** A method for subband processing of an input signal comprising:

an analysis step that includes decomposing the input signal into two subband signals for establishing two subbands by decimation filtering, subsequently down-sampling and subsequently basis-filtering in a first branch (2), and, in a second branch (3), allpass-filtering and subtracting an up-sampled and subsequently interpolation-filtered signal of the first branch (2) from the allpass filtered input signal;

a subband signal processing step to process the two subband signals from the first and second branch (2, 3) in the corresponding subbands and to generate two processed subband signals; and

a synthesis step for synthesizing an output signal by adding the processed subband signal of the second branch and the up-sampled and subsequently interpolation-filtered processed subband signal of the first branch (2); the method being **characterized in that**

either the decimation filtering or the first interpolation filtering or both include filtering with an infinite impulse response (IIR), and

the allpass filtering phase response is adapted to compensate for the phase response of those of the decimation filtering or the first interpolation filtering which include filtering with an infinite impulse response.

**15.** The method of claim 14, where the basis-filtering includes filtering with a finite impulse response (FIR).

**16.** The method of claim 14, where the basis-filtering includes filtering with a linear phase infinite impulse response (IIR).

**17.** The method of one of claims 14-16, where the decimation-filtering step and at least one of the interpolation-filtering steps includes filtering in accordance with identical transfer functions.

**18.** The method of one of claims 14-17, where the decimation-filtering and at least one interpolation filtering includes filtering in accordance with low pass filter characteristics.

**19.** The method of one of claims 14-18, where the decimation-filtering step and at least one interpolation filtering step includes filtering with a minimum phase infinite impulse response (IIR).

**20.** The method of one of claims 14-19, where in the second branch the signal is delayed.

**21.** The method of one of claims 14-20, where the basis-filtering step includes multirate-complementary filtering.

**22.** The method of claim 21, where the basis filtering step comprises supplying a basis filter input signal to two signal branches, a first branch of which includes a second decimation filtering step, a subsequent second down-sampling step and a subsequent sub-basis filtering step, and the second branch includes a second signal delaying step and a second subtracting step where an up-sampled and subsequently interpolation-filtered signal of the first branch is subtracted from the delayed basis filter input signal to form a basis filter output signal.

**23.** The method of claim 22, where

at least one of second decimation filtering step and the third interpolation filtering step or both include filtering with an infinite impulse response (IIR);

a second allpass filtering step is performed before or after the second signal delaying step; and

the second allpass filtering step exhibits a phase response adapted to compensate for the phase response of the second decimation filtering step or the third interpolation filtering step or both.

**24.** The method of claim 22 or 23, where the second delaying step includes filtering in accordance with a phase response adapted to compensate for the phase response of at least the sub-basis filter (30).

**Patentansprüche**

**1.** Vorrichtung zur Teilbandverarbeitung eines Eingangssignals, umfassend:

eine Analysefilterbank (1) mit zwei Signalzweigen (2, 3) zum Herstellen von zwei Teilbändern und Zerlegen des Eingangssignals in zwei Teilbandsignale, wobei der erste Zweig (2) derselben ein Dezimierungsfilter (4), eine anschließende Abtastratensenkungseinheit (5) und ein anschließendes Basisfilter (6) aufweist und der zweite Zweig (3) ein Allpassfilter (7) und einen Subtraktor (9) aufweist, der dem Allpassfilter (7) nachgeschaltet verbunden ist und über eine erste Abtastratenerhöhungseinheit (10) und einen anschließenden ersten Interpolationsfilter (11) dem Basisfilter (6) nachgeschaltet verbunden ist; zwei Teilbandsignalprozessoren (12, 13), denen die zwei Teilbandsignale aus der Analysefilterbank (1) zugeführt werden, um die Teilbandsignale in den entsprechenden Teilbändern zu verarbeiten und zwei verarbeitete Teilbandsignale zu erzeugen; und eine Synthesefilterbank (14) zum Synthetisieren eines Ausgangssignals, wobei die Synthesefilterbank (14) einen Addierer (15) aufweist, dem das verarbeitete Teilbandsignal des zweiten Zweigs (3) zugeführt wird und dem das verarbeitete Teilbandsignal des ersten Zweigs (2) über eine zweite Abtastratenerhöhungseinheit (16) und ein anschließendes zweites Interpolationsfilter (17) zugeführt wird; wobei die Vorrichtung **dadurch gekennzeichnet ist, dass** entweder das Dezimierungsfilter (4) ein Filter mit unendlicher Impulsantwort (IIR) ist oder das erste Interpolationsfilter (11) ein Filter mit unendlicher Impulsantwort (IIR) ist oder beide Filter mit unendlicher Impulsantwort (IIR) sind; und das Allpassfilter (7) eine Phasenantwort aufweist, die dazu angepasst ist, die Phasenantwort von denjenigen von dem Dezimierungsfilter (4) und dem ersten Interpolationsfilter (11), die Filter mit unendlicher Impulsantwort (IIR) sind, anzupassen.

2. Vorrichtung nach Anspruch 1, wobei das Basisfilter (6) ein Filter mit endlicher Impulsantwort (FIR) umfasst.

3. Vorrichtung nach Anspruch 1, wobei das Basisfilter (6) ein Linearphasenfilter mit unendlicher Impulsantwort (IIR) umfasst.

4. Vorrichtung nach einem der Ansprüche 1-3, wobei der zweite Zweig eine erste Verzögerungseinheit (8) aufweist, die in Reihe mit dem Allpassfilter (7) verbunden ist und eine Phasenantwort aufweist, die dazu angepasst ist, die Phasenantwort von wenigstens dem Basisfilter zu kompensieren.

5. Vorrichtung nach einem der Ansprüche 1-4, wobei das Dezimierungsfilter (4), das erste Interpolationsfilter (11) und das zweite Interpolationsfilter (17) identische Transferfunktionen aufweisen.

6. Vorrichtung nach einem der Ansprüche 1-5, wobei das Dezimierungsfilter (4), das erste Interpolationsfilter (11) und das zweite Interpolationsfilter (17) Tiefpassfilter sind.

7. Vorrichtung nach einem der Ansprüche 1-6, wobei das Dezimierungsfilter (4), das erste Interpolationsfilter (11) und das zweite Interpolationsfilter (17) Minimalphasenfilter mit Impulsantwort (IIR) sind.

8. Vorrichtung nach einem der Ansprüche 1-7, wobei in der Analysefilterbank (1) das Dezimierungsfilter (4) der Abtastratensenkungseinheit (6) und dem Basisfilter (6) vorgeschaltet verbunden ist.

9. Vorrichtung nach einem der Ansprüche 1-8, ferner umfassend n Analysefilterbanken, n Teilbandsignalprozessoren und n Synthesefilterbanken, die derart kaskadiert sind, dass der erste Zweig von wenigstens einer Analysefilterbank den ersten und den zweiten Zweig einer anschließenden Analysefilterbank in der Kaskade aufweist.

10. Vorrichtung nach einem der Ansprüche 1-9, wobei das Basisfilter (6) ein multiratenkomplementäres Filter ist.

11. Vorrichtung nach einem der Ansprüche 1-10, wobei das Basisfilter (6) zwei Signalzweige umfasst, denen ein Subbasisfiltereingangssignalzugeführt wird, wobei der erste Zweig derselben ein zweites Dezimierungsfilter (28), eine zweite Abtastratensenkungseinheit (29) und ein weiteres Basisfilter (30) aufweist und der zweite Zweig eine zweite Verzögerungseinheit (33) und einen zweiten Subtraktor aufweist, der ein Basisfilterausgangssignal bereitstellt; wobei der zweite Subtraktor der zweiten Verzögerungseinheit (33) nachgeschaltet verbunden ist und über eine drittes Abtastratenerhöhungseinheit (31) und ein anschließendes drittes Interpolationsfilter (32) dem weiteren Basisfilter (30) nachgeschaltet verbunden ist.

12. Vorrichtung nach Anspruch 11, wobei entweder das zweite Dezimierungsfilter (28) ein Filter mit unendlicher Impulsantwort (IIR) ist oder das dritte Interpolationsfilter (32) ein Filter mit unendlicherImpulsantwort (IIR) ist oder beide Filter mit unendlicher Impulsantwort (IIR) sind;

ein zweites Allpassfilter (34) in Reihe mit der zweiten Verzögerungseinheit (33) verbunden ist; und

das zweite Allpassfilter (34) eine Phasenantwort aufweist, die dazu angepasst ist, die Phasenantwort des zweiten Dezimierungsfilters (28) oder des dritten Interpolationsfilters (32) oder beider zu kompensieren.

13. Vorrichtung nach 11 oder 12, wobei die zweite Verzögerungseinheit (33) eine Phasenantwort aufweist, die dazu angepasst ist, die Phasenantwort von wenigstens dem Subbasisfilter (30) zu kompensieren.

14. Verfahren zur Teilbandverarbeitung eines Eingangssignals, umfassend:

einen Analyseschritt, der das Zerlegen des Eingangssignals in zwei Teilbandsignale, um durch Dezimierungsfilterung zwei Teilbänder zu erzeugen, anschließendes Senken der Abtastrate und anschließendes Basisfiltern in einem ersten Zweig (2) und in einem zweiten Zweig (3), Allpassfiltern und Subtrahieren eines einer Abtastratenerhöhung unterzogenen und anschließend interpolationsgefilterten Signals des ersten Zweigs (2) von dem allpassgefilterten Eingangssignal umfasst;

einen Teilbandsignalverarbeitungsschritt zum Verarbeiten der zwei Teilbandsignale von dem ersten und zweiten Zweig (2, 3) in den entsprechenden Teilbänder und zum Erzeugen zweier verarbeiteter Teilbandsignale; und

einen Syntheseschritt zum Synthetisieren eines Ausgangssignals durch Addieren des verarbeiteten Teilbandsignals des zweiten Zweigs und des einer Abtastratenerhöhung unterzogenen und anschließend interpolationsgefilterten verarbeiteten Teilbandsignals des ersten Zweigs (2); wobei das Verfahren **dadurch gekennzeichnet ist, dass**

entweder das Dezimierungsfiltern oder das erste Interpolationsfiltern oder beide ein Filtern mit einer unendlichen Impulsantwort (IIR) einschließen, und

die Allpassfilterungsphasenantwort dazu angepasst ist, die Phasenantwort von denjenigen von dem Dezimierungsfiltern oder dem ersten Interpolationsfiltern zu kompensieren, die ein Filtern mit einer unendlichen Impulsantwort einschließen.

15. Verfahren nach Anspruch 14, wobei das Basisfiltern das Filtern mit einer endlichen Impulsantwort (FIR) einschließt.

16. Verfahren nach Anspruch 14, wobei das Basisfiltern das Linearphasenfiltern mit unendlicher Impulsantwort (IIR) einschließt.

17. Verfahren nach einem der Ansprüche 14-16, wobei der Dezimierungsfilterungsschritt und wenigstens einer von den Interpolationsfilterungsschritten das Filtern gemäß identischen Transferfunktionen einschließen.

18. Verfahren nach einem der Ansprüche 14-17, wobei das Dezimierungsfiltern und wenigstens ein Interpolationsfiltern das Filtern gemäß Tiefpassfilterkennlinien einschließen.

19. Verfahren nach einem der Ansprüche 14-18, wobei der Dezimierungsfilterungsschritt und wenigstens ein Interpolationsfilterungsschritt das Minimalphasenfiltern mit einer minimalen unendlichen Impulsantwort (IIR) einschließen.

20. Verfahren nach einem der Ansprüche 14-19, wobei das Signal im zweiten Zweig verzögert wird.

21. Verfahren nach einem der Ansprüche 14-20, wobei der Basisfilterungsschritt multiratenkomplementäres Filtern einschließt.

22. Verfahren nach Anspruch 21, wobei der Basisfilterungsschritt das Zuführen eines Basisfiltereingangssignals an zwei Signalzweige umfasst, von denen ein erster Zweig einen zweiten Dezimierungsfilterungsschritt, einen anschließenden zweiten Abtastratensenkungsschritt und einen anschließenden Subbasisfilterungsschritt einschließt, und der zweite Zweig einen zweiten Signalverzögerungsschritt und einen zweiten Subtraktionsschritt einschließt, wobei ein einer Abtastratenerhöhung unterzogenes und anschließend interpolationsgefiltertes Signal des ersten Zweigs von dem verzögerten Basisfiltereingangssignal subtrahiert wird, um ein Basisfilterausgangssignal zu bilden.

23. Verfahren nach Anspruch 22, wobei

wenigstens einer von dem zweiten Dezimierungsfilterungsschritt und dem dritten Interpolationsfilterungsschritt oder beide das Filtern mit einer unendlichen Impulsantwort (IIR) einschließen;

ein zweiter Allpassfilterungsschritt vor oder nach dem zweiten Signalverzögerungsschritt durchgeführt wird; und

der zweite Allpassfilterungsschritt eine Phasenantwort aufweist, die dazu angepasst ist, die Phasenantwort des zweiten Dezimierungsfilterungsschritts oder des dritten Interpolationsfilterungsschritts oder beider zu kompensieren.

**24.** Verfahren nach Anspruch 22 oder 23, wobei der zweite Verzögerungsschritt das Filtern gemäß einer Phasenantwort einschließt, die dazu angepasst ist, die Phasenantwort von wenigstens dem Subbasisfilter (30) zu kompensieren.


## Revendications

**1.** Appareil pour le traitement en sous-bande d'un signal d'entrée comprenant :

un banc de filtrage d'analyse (1) comprenant deux branches de signal (2, 3) pour établir deux bandes secondaires et pour décomposer le signal d'entrée en deux signaux de sous-bande, dont la première branche (2) comprend un filtre de décimation (4), une unité de sous-échantillonnage ultérieure (5) et un filtre de base ultérieur (6), et la seconde branche (3) comprend un filtre passe-tout (7) et un soustracteur (9) qui est connecté en aval du filtre passe-tout (7) et qui est connecté en aval du filtre de base (6) par l'intermédiaire d'une première unité de suréchantillonnage (10) et d'un premier filtre d'interpolation ultérieur (11) ;
deux processeurs de signal de sous-bande (12, 13) munis des deux signaux de sous-bande provenant du banc de filtrage d'analyse (1) pour le traitement des signaux de sous-bande dans les sous-bandes correspondantes et pour générer deux signaux de sous-bande traités ; et
un banc de filtrage de synthèse (14) pour synthétiser un signal de sortie, le banc de filtrage de synthèse (14) comprend un additionneur (15) qui est muni du signal de sous-bande traité de la seconde branche (3) et qui est muni du signal de sous-bande traité de la première branche (2) par l'intermédiaire d'une deuxième unité de suréchantillonnage (16) et d'un second filtre d'interpolation ultérieur (17) ; l'appareil étant
**caractérisé en ce que**
soit le filtre de décimation (4) est un filtre à réponse d'impulsion infinie (IIR) soit le premier filtre d'interpolation (11) est un filtre à réponse d'impulsion infinie (IIR) soit l'un et l'autre sont des filtres à réponse d'impulsion infinie (IIR) ; et
le filtre passe-tout (7) possède une réponse de phase adaptée pour compenser la réponse de phase de ces éléments parmi le filtre de décimation (4) et le premier filtre d'interpolation (11) qui sont des filtres à réponse d'impulsion infinie (IIR).

**2.** Appareil selon la revendication 1, où le filtre de base (6) comprend un filtre à réponse d'impulsion finie (FIR).

**3.** Appareil selon la revendication 1, où le filtre de base (6) comprend un filtre à réponse d'impulsion infinie (IIR) de phase linéaire.

**4.** Appareil selon l'une des revendications 1 à 3, où la seconde branche comprend une première unité de retard (8) qui est connectée en série avec le filtre passe-tout (7) et qui possède une réponse de phase adaptée pour compenser la réponse de phase d'au moins le filtre de base.

**5.** Appareil selon l'une des revendications 1 à 4, où le filtre de décimation (4), le premier filtre d'interpolation (11) et le second filtre d'interpolation (17) possèdent des fonctions de transfert identiques.

**6.** Appareil selon l'une des revendications 1 à 5, où le filtre de décimation (4), le premier filtre d'interpolation (11) et le deuxième filtre d'interpolation (17) sont des filtres passe-bas.

**7.** Appareil selon l'une des revendications 1 à 6, où le filtre de décimation (4), le premier filtre d'interpolation (11) et le deuxième filtre d'interpolation (17) sont des filtres à réponse d'impulsion (IIR) de phase minimale.

**8.** Appareil selon l'une des revendications 1 à 7, où, dans le banc de filtrage d'analyse (1), le filtre de décimation (4) est connecté en amont de l'unité de sous-échantillonnage (6) et du filtre de base (6).

**9.** Appareil selon l'une des revendications 1 à 8, comprenant en outre n bancs de filtrage d'analyse, n processeurs de signal de sous-bande et n bancs de filtrage de synthèse qui sont en cascade de telle sorte que la première branche d'au moins un banc de filtrage d'analyse comprend les première et seconde branches d'un banc de filtrage d'analyse ultérieur dans la cascade.

**10.** Appareil selon l'une des revendications 1 à 9, où le filtre de base (6) est un filtre complémentaire à débits multiples.

**11.** Appareil selon l'une des revendications 1 à 10, où le filtre de base (6) comprend deux branches de signal munies d'un signal d'entrée de sous-filtre de base, dont la première branche comprend un second filtre de décimation (28), une seconde unité de sous-échantillonnage (29) et un autre filtre de base (30), et la seconde branche comprend une seconde unité de retard (33) et un second soustracteur qui fournit un signal de sortie de filtre de base ; le second soustracteur est connecté en aval de la seconde unité de retard (33) et est connecté en aval du filtre de base supplémentaire (30) par l'intermédiaire d'une troisième unité de suréchantillonnage (31) et d'un troisième filtre d'interpolation ultérieur (32).

**12.** Appareil selon la revendication 11, où
soit le second filtre de décimation (28) est un filtre à réponse d'impulsion infinie (IIR) soit le troisième filtre d'interpolation (32) est un filtre à réponse d'impulsion infinie (IIR) soit l'un et l'autre sont des filtres à réponse d'impulsion infinie (IIR) ;
un second filtre passe-tout (34) est connecté en série à la seconde unité de retard (33) ; et
le second filtre passe-tout (34) possède une réponse de phase adaptée pour compenser la réponse de phase du second filtre de décimation (28) ou le troisième filtre d'interpolation (32) ou l'un et l'autre.

**13.** Appareil selon la revendication 11 ou 12, où la seconde unité de retard (33) possède une réponse de phase adaptée pour compenser la réponse de phase d'au moins le sous-filtre de base (30).

**14.** Procédé pour le traitement en sous-bande d'un signal d'entrée comprenant :

une étape d'analyse qui comprend la décomposition du signal d'entrée en deux signaux de sous-bande pour établir deux sous-bandes par filtrage de décimation, puis le sous-échantillonnage puis le filtrage de base dans une première branche (2) et, dans une seconde branche (3), le filtrage passe-tout et la soustraction d'un signal suréchantillonné puis filtré par interpolation de la première branche (2) à partir du signal d'entrée ayant subi un filtrage passe-tout ;
une étape de traitement de signal de sous-bande pour traiter les deux signaux de sous-bande provenant des première et seconde branches (2, 3) dans les sous-bandes correspondantes et pour générer deux signaux de sous-bande traités ; et
une étape de synthèse pour synthétiser un signal de sortie en ajoutant le signal de sous-bande traité de la seconde branche et le signal de sous-bande traité suréchantillonné puis filtré par interpolation de la première branche (2) ; le procédé étant **caractérisé en ce que**
soit le filtrage de décimation soit le premier filtrage d'interpolation soit l'un et l'autre comprennent un filtrage avec une réponse d'impulsion infinie (IIR), et
la réponse de phase du filtre passe-tout est adaptée pour compenser la réponse de phase de ces filtrages parmi le filtrage de décimation ou le premier filtrage d'interpolation qui comprennent un filtrage avec une réponse d'impulsion infinie.

**15.** Procédé selon la revendication 14, où le filtrage de base comprend un filtrage avec une réponse d'impulsion finie (FIR).

**16.** Procédé selon la revendication 14, où le filtrage de base comprend un filtrage avec une réponse d'impulsion infinie (IIR) de phase linéaire.

**17.** Procédé selon l'une des revendications 14 à 16, où l'étape de filtrage de décimation et au moins l'une des étapes de filtrage d'interpolation comprennent un filtrage conformément à des fonctions de transfert identiques.

**18.** Procédé selon l'une des revendications 14 à 17, où le filtrage de décimation et au moins un filtrage d'interpolation comprennent un filtrage conformément à des caractéristiques de filtre passe-bas.

**19.** Procédé selon l'une des revendications 14 à 18, où l'étape de filtrage de décimation et au moins une étape de filtrage d'interpolation comprennent un filtrage avec une réponse d'impulsion infinie (IIR) de phase minimale.

**20.** Procédé selon l'une des revendications 14 à 19, où, dans la seconde branche, le signal est retardé.

**21.** Procédé selon l'une des revendications 14 à 20, où l'étape de filtrage de base comprend un filtrage complémentaire à débits multiples.

**22.** Procédé selon la revendication 21, où l'étape de filtrage de base comprend la fourniture d'un signal d'entrée de filtre de base à deux branches de signal, dont une première branche comprend une seconde étape de filtrage de décimation, une seconde étape de sous-échantillonnage ultérieure et une étape de sous-filtrage de base ultérieure, et la seconde branche comprend une seconde étape de retardement de signal et une seconde étape de soustraction où un signal suréchantillonné puis filtré par interpolation de la première branche est soustrait du signal d'entrée de filtre de base retardé pour former un signal de sortie de filtre de base.

**23.** Procédé selon la revendication 22, où
au moins l'une parmi la seconde étape de filtrage de décimation et la troisième étape de filtrage d'interpolation ou l'une et l'autre comprennent un filtrage avec une réponse d'impulsion infinie (IIR) ;
une seconde étape de filtrage passe-tout est effectuée avant ou après la seconde étape de retardement de signal ; et
la seconde étape de filtrage passe-tout présente une réponse de phase adaptée pour compenser la réponse de phase de la seconde étape de filtrage de décimation ou la troisième étape de filtrage d'interpolation ou l'une et l'autre.

**24.** Procédé selon la revendication 22 ou 23, où la seconde étape de retard comprend un filtrage conformément à une réponse de phase adaptée pour compenser la réponse de phase d'au moins le sous-filtre de base (30).

**FIG 1**

**FIG 5**

**FIG 2**

**FIG 3**

Bode diagram of a 4th-order lowpass filter

Frequency (Hz)

Frequency (Hz)

Bode diagram of a 2nd-order allpass filter

Frequency (Hz)

Frequency (Hz)

**FIG 4**

**FIG 6**

**FIG 7**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R.G. LYONS.** Understanding Digital Signal Processing. Addison Wesley Longman, Inc, 1997